# EUROPEAN PATENT APPLICATION

(11) **EP 4 503 149 A1**
(43) Date of publication of application: **05.02.2025**
(21) Application number: 22966840.5
(22) Date of filing: 30.11.2022
(51) Int. Cl.: H01L 33/00

(54) **LIGHT-EMITTING DIODE CHIP AND PREPARATION METHOD THEREFOR, AND DISPLAY APPARATUS**

(71) Applicant: BOE Technology Group Co., Ltd., Beijing 100015 (CN); BOE MLED Technology Co., Ltd., Beijing 100176 (CN)
(72) Inventor: LU, Yuanda, Beijing 100176 (CN); MA, Junjie, Beijing 100176 (CN); SUN, Yuanhao, Beijing 100176 (CN); ZHAO, Jiawei, Beijing 100176 (CN); XIONG, Zhijun, Beijing 100176 (CN); LI, Xueqiao, Beijing 100176 (CN); YANG, Shanwei, Beijing 100176 (CN); CHU, Yutian, Beijing 100176 (CN); QI, Linxia, Beijing 100176 (CN)
(74) Representative: Potter Clarkson
(86) International application number: PCT/CN2022/135577
(87) International publication number: WO 2024/113247

(57) **Abstract**

Provided are a light emitting diode chip, a method of manufacturing the same, and a display device. The light emitting diode chip includes: a base substrate and at least two light emitting structures arranged on the base substrate. The at least two light emitting structures are spaced apart and are sequentially connected in series. At least one of the light emitting structures includes a first semiconductor layer, a light emitting layer, a second semiconductor layer, a first insulation layer, a current spreading layer and a first electrode stacked in sequence on the base substrate. The at least one light emitting structure includes a first via hole in the first insulation layer, the first electrode is electrically connected to the current spreading layer, and the current spreading layer is electrically connected to the second semiconductor layer through the first via hole. An orthographic projection of the first via hole on the base substrate falls within that of the current spreading layer, and the orthographic projection of the current spreading layer on the base substrate falls within that of the second semiconductor layer.

## Description

### TECHNICAL FIELD

The present disclosure relates to the field of display technology, and in particular to a light emitting diode chip and a method of manufacturing the same, and a display device.

### BACKGROUND

The Light Emitting Diode (LED) technology has been developed for nearly 30 years, and its application range has been continuously expanded. For example, the light emitting diode may be applied in the display field and served as the backlight source of the display device or as the LED display screen. With the development of technology, Mini Light Emitting Diode (Mini LED) has gradually become a research hotspot in the field of display technology. For example, the technology of Mini LED cooperating with Thin Film Transistor (TFT) drive has advantages of productivity, costs and downward compatibility with Micro Light Emitting Diode (Micro LED), and has gradually become the mainstream research direction in the field of display technology. However, in practice, the current of the Mini LED (at µA level) is higher than the current of Organic Light-Emitting Diode (OLED) (at nA level), resulting in the high power consumption of TFT, and the overall power consumption is high, which is not conducive for product promotion.

The above information disclosed in this section is only for the understanding of the background of the inventive concept of the present disclosure. Therefore, the above information may contain information that does not constitute the related art.

### SUMMARY

In order to solve at least one aspect of the above-mentioned problems, the embodiments of the present disclosure provide a light emitting diode chip and a method of manufacturing the same, and a display device.

In an aspect, a light emitting diode chip is provided, including: a base substrate; and at least two light emitting structures arranged on the base substrate, orthographic projections of the at least two light emitting structures on the base substrate are spaced apart, and the at least two light emitting structures are sequentially connected in series, at least one of the light emitting structures includes: a first semiconductor layer arranged on the base substrate; a light emitting layer arranged on a side of the first semiconductor layer away from the base substrate; a second semiconductor layer arranged on a side of the light emitting layer away from the base substrate; a first insulation layer arranged on a side of the second semiconductor layer away from the base substrate; a current spreading layer arranged on a side of the first insulation layer away from the base substrate; and a first electrode arranged on a side of the current spreading layer away from the base substrate, the at least one light emitting structure includes a first via hole located in the first insulation layer, the first electrode is electrically connected to the current spreading layer, and the current spreading layer is electrically connected to the second semiconductor layer through the first via hole; and an orthographic projection of the first via hole on the base substrate falls within an orthographic projection of the current spreading layer on the base substrate, and the orthographic projection of the current spreading layer on the base substrate falls within an orthographic projection of the second semiconductor layer on the base substrate.

According to some exemplary embodiments, in one and same light emitting structure of the at least one light emitting structure, a plurality of first via holes are arranged in the first insulation layer, and the current spreading layer is electrically connected to the second semiconductor layer through the plurality of first via holes; and orthographic projections of the plurality of first via holes on the base substrate fall within the orthographic projection of the current spreading layer on the base substrate.

According to some exemplary embodiments, the light emitting diode chip further includes a bridging conductive portion arranged on a side of the current spreading layer away from the base substrate, and the bridging conductive portion includes a first part and a second part; and the at least two light emitting structures include a first light emitting structure and a second light emitting structure that are adjacent to each other, the first light emitting structure and the second light emitting structure are electrically connected through the bridging conductive portion, the first part of the bridging conductive portion is electrically connected to the second semiconductor layer of the first light emitting structure, the second part of the bridging conductive portion is electrically connected to the first semiconductor layer of the second light emitting structure, an orthographic projection of the first part of the bridging conductive portion on the base substrate falls within an orthographic projection of the second semiconductor layer of the first light emitting structure on the base substrate, and an orthographic projection of the second part of the bridging conductive portion on the base substrate falls within an orthographic projection of the first semiconductor layer of the second light emitting structure on the base substrate.

According to some exemplary embodiments, the orthographic projection of the first part of the bridging conductive portion on the base substrate overlaps at least partially with an orthographic projection of the current spreading layer of the first light emitting structure on the base substrate.

According to some exemplary embodiments, the orthographic projection of the first via hole on the base substrate overlaps at least partially with the orthographic projection of the first part of the bridging conductive portion on the base substrate.

According to some exemplary embodiments, the orthographic projection of at least one of the plurality of first via holes on the base substrate overlaps at least partially with the orthographic projection of the first part of the bridging conductive portion on the base substrate.

According to some exemplary embodiments, the orthographic projection of the first via hole on the base substrate does not overlap with the orthographic projection of the first part of the bridging conductive portion on the base substrate.

According to some exemplary embodiments, the orthographic projection of the first part of the bridging conductive portion on the base substrate is spaced apart from the orthographic projection of the first via hole on the base substrate, and an orthographic projection of a partial region of the first part of the bridging conductive portion on the base substrate surrounds the orthographic projection of the first via hole on the base substrate.

According to some exemplary embodiments, the light emitting diode chip further includes a first reflection layer between the first insulation layer and the current spreading layer, a light reflectivity of the first reflection layer is greater than a light reflectivity of the bridging conductive portion, and the orthographic projection of the first via hole on the base substrate falls within an orthographic projection of the first reflection layer on the base substrate.

According to some exemplary embodiments, the light emitting diode chip further includes a second reflection layer on a side of the current spreading layer away from the base substrate, and the second reflection layer includes a Bragg reflector.

According to some exemplary embodiments, the light emitting diode chip further includes a second via hole in the second reflection layer, the first electrode is electrically connected to the current spreading layer through the second via hole, and the orthographic projection of the first via hole on the base substrate falls within an orthographic projection of the second via hole on the base substrate.

According to some exemplary embodiments, in one and same light emitting structure of the at least one light emitting structure, the orthographic projections of the plurality of first via holes on the base substrate are arranged in an array in a first direction and a second direction intersecting with the first direction.

According to some exemplary embodiments, in one and same light emitting structure of the at least one light emitting structure, a ratio of an area of the orthographic projection of the current spreading layer on the base substrate to an area of the orthographic projection of the second semiconductor layer on the base substrate is less than 0.1.

According to some exemplary embodiments, in one and same light emitting structure of the at least one light emitting structure, a ratio of an area of the orthographic projection of each of the plurality of first via holes on the base substrate to an area of the orthographic projection of the second semiconductor layer on the base substrate is less than 0.1; and/or in one and same light emitting structure of the at least one light emitting structure, the orthographic projection of the current spreading layer on the base substrate substantially coincides with the orthographic projection of the second semiconductor layer on the base substrate.

According to some exemplary embodiments, the orthographic projection of the first via hole on the base substrate is a circle, the orthographic projection of the partial region of the first part of the bridging conductive portion on the base substrate is a ring, and the ring-shaped partial region of the first part of the bridging conductive portion is substantially concentric with the circular first via hole.

According to some exemplary embodiments, the orthographic projection of the first reflection layer on the base substrate overlaps at least partially with the orthographic projection of the first part of the bridging conductive portion on the base substrate.

According to some exemplary embodiments, the light emitting diode chip further includes a second electrode and a third via hole, the third via hole is located in the second reflection layer, the second electrode is electrically connected to the first semiconductor layer of one light emitting structure through the third via hole, and an orthographic projection of the third via hole on the base substrate is spaced apart from the orthographic projection of the first via hole on the base substrate.

According to some exemplary embodiments, the light emitting diode chip includes three or more light emitting structures, each of the light emitting structures includes the first via hole located in the first insulation layer, the first electrode is electrically connected to the current spreading layer, and the current spreading layer is electrically connected to the second semiconductor layer through the first via hole; and the orthographic projection of the first via hole on the base substrate falls within the orthographic projection of the current spreading layer on the base substrate, and the orthographic projection of the current spreading layer on the base substrate falls within the orthographic projection of the second semiconductor layer on the base substrate.

In another aspect, a display device is provided, including the light emitting diode chip as described above.

In yet another aspect, a method of manufacturing a light emitting diode chip is provided, including: providing a base substrate; and forming at least two light emitting structures on the base substrate, the at least two light emitting structures are spaced apart and are sequentially connected in series, the forming at least two light emitting structures on the base substrate includes: forming a first semiconductor layer on the base substrate; forming a light emitting layer on a side of the first semiconductor layer away from the base substrate; forming a second semiconductor layer on a side of the light emitting layer away from the base substrate; forming a first insulation layer on a side of the second semiconductor layer away from the base substrate; forming a first via hole in the first insulation layer through a dry etching process; forming a current spreading layer on a side of the first insulation layer away from the base substrate; and forming a first electrode on a side of the current spreading layer away from the base substrate, the first electrode is electrically connected to the current spreading layer, and the current spreading layer is electrically connected to the second semiconductor layer through the first via hole; and an orthographic projection of the first via hole on the base substrate falls within an orthographic projection of the current spreading layer on the base substrate, and the orthographic projection of the current spreading layer on the base substrate falls within an orthographic projection of the second semiconductor layer on the base substrate.

### BRIEF DESCRIPTION OF THE DRAWINGS

Through the following descriptions of the present disclosure with reference to the drawings, other objectives and advantages of the present disclosure would be clear and the present disclosure would be understood comprehensively.
FIG. 1A is a schematic cross-sectional view of a light emitting diode chip according to some exemplary embodiments of the present disclosure;
FIG. 1B is a schematic cross-sectional view of light emitting structures connected in series according to some exemplary embodiments of the present disclosure;
FIG. 1C is a schematic plan view of light emitting structures connected in series according to some exemplary embodiments of the present disclosure;
FIG. 2 is a partially enlarged schematic cross-sectional view of a light emitting diode chip according to some exemplary embodiments of the present disclosure;
FIG. 3 is a schematic cross-sectional view of a light emitting diode chip according to some other exemplary embodiments of the present disclosure;
FIG. 4A is a cross-sectional view of a connection structure between a bridging conductive portion and a first light emitting structure according to some other exemplary embodiments of the present disclosure;
FIG. 4B is a plan view of a connection structure between a bridging conductive portion and a first light emitting structure according to some other exemplary embodiments of the present disclosure;
FIG. 5 is a plan view of a connection structure between a bridging conductive portion and a first light emitting structure according to still other exemplary embodiments of the present disclosure;
FIG. 6 is a comparative plan view of connection structures between a bridging conductive portion and a first light emitting structure according to two exemplary embodiments of the present disclosure;
FIG. 7 is a cross-sectional view of a connection structure between a bridging conductive portion and a first light emitting structure according to still other exemplary embodiments of the present disclosure;
FIG. 8 is a schematic diagram of a display device according to some exemplary embodiments of the present disclosure; and
FIGS. 9A to 17A are schematic cross-sectional views of structures that are formed after some steps of a method of manufacturing a light emitting diode chip according to some exemplary embodiments of the present disclosure are performed, respectively;
FIGS. 9B to 17B are schematic plan views of structures that are formed after some steps of a method of manufacturing a light emitting diode chip according to some exemplary embodiments of the present disclosure are performed, respectively.

It should be noted that for the sake of clarity, in the drawings used to describe the embodiments of the present disclosure, sizes of layers, structures or regions may be enlarged or reduced, that is, these drawings are not drawn according to actual scale.

### DETAILED DESCRIPTION OF EMBODIMENTS

In the following descriptions, for the purpose of explanation, many specific details are set forth to provide a comprehensive understanding of various exemplary embodiments. However, it may be understood that the various exemplary embodiments may be implemented without these specific details or with one or more equivalent arrangements. In other cases, well-known structures and devices are shown in block diagrams in order to avoid unnecessarily obscuring the various exemplary embodiments. In addition, the various exemplary embodiments may be different, but need not be exclusive. For example, without departing from the inventive concept of the present disclosure, specific shapes, configurations and characteristics of an exemplary embodiment may be used or implemented in another exemplary embodiment.

In the drawings, for clarity and/or description purposes, sizes and relative sizes of elements may be enlarged. Accordingly, the size and relative size of each element need not to be limited to those shown in the drawings. When the exemplary embodiments may be implemented differently, a specific process sequence may be different from a described sequence. For example, two consecutively described processes may be performed substantially simultaneously or in a reverse order. In addition, the same reference numerals represent the same element.

When an element is described as being "on", "connected to" or "coupled to" another element, the element may be directly on the another element, directly connected to the another element, or directly coupled to the another element, or an intermediate element may be provided. However, when an element is described as being "directly on", "directly connected to" or "directly coupled to" another element, no intermediate element is provided. Other terms and/or expressions used to describe the relationship between elements, for example, "between" and "directly between", "adjacent" and "directly adjacent", "on" and "directly on", and so on, should be interpreted in a similar manner. In addition, the term "connected" may refer to a physical connection, an electrical connection, a communication connection, and/or a fluid connection. In addition, X-axis, Y-axis and Z-axis are not limited to three axes of a rectangular coordinate system, and may be interpreted in a broader meaning. For example, the X-axis, the Y-axis and the Z-axis may be perpendicular to each other, or may represent different directions that are not perpendicular to each other. For the objective of the present disclosure, "at least one of X, Y and Z" and "at least one selected from a group consisting of X, Y and Z" may be interpreted as only X, only Y, only Z, or any combination of two or more of X, Y and Z, such as XYZ, XYY, YZ and ZZ. As used herein, the term "and/or" includes any and all combinations of one or more of the listed related items.

It should be understood that, although terms "first," "second" and so on may be used here to describe different elements, these elements should not be limited by these terms. These terms are only used to distinguish one element from another. For example, without departing from the scope of the exemplary embodiments, a first element may be named as a second element, and similarly, a second element may be named as a first element.

Herein, an inorganic light emitting diode refers to a light emitting element made of an inorganic material, and LED refers to an inorganic light emitting element different from OLED. Specifically, the inorganic light emitting element may include a mini light emitting diode (Mini LED) and a micro light emitting diode (Micro LED). Mini LED refers to a small light emitting diode with a grain size between micro LED and traditional LED. Typically, the grain size of Mini LED may range from 100 microns to 300 microns.

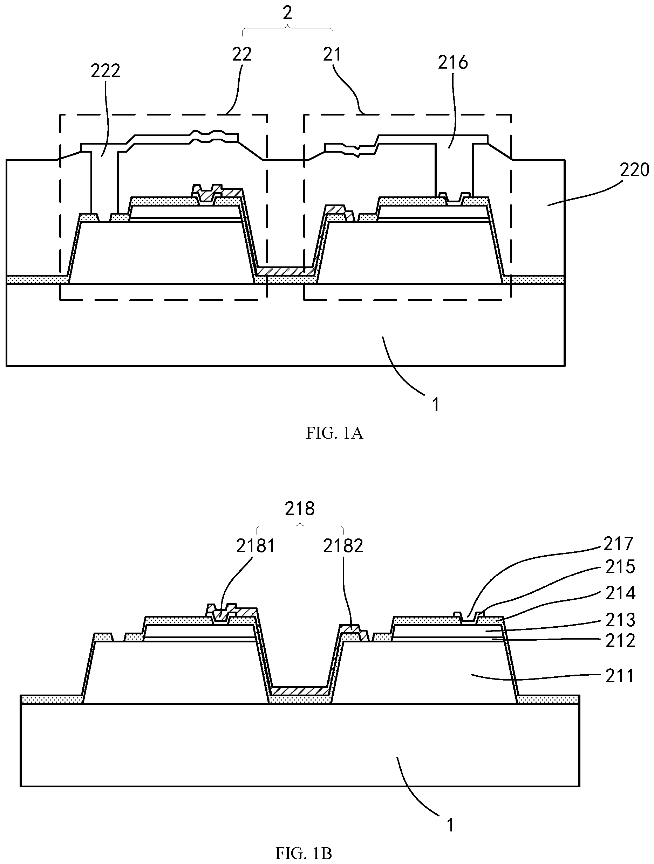

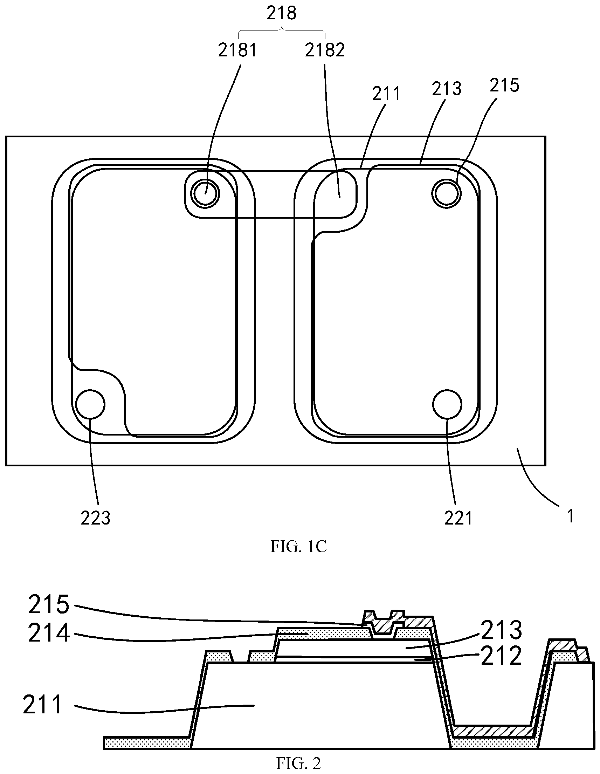

FIG. 1A is a schematic cross-sectional view of a light emitting diode chip according to some exemplary embodiments of the present disclosure. FIG. 1B is a schematic cross-sectional view of light emitting structures connected in series according to some exemplary embodiments of the present disclosure. FIG. 1C is a schematic plan view of light emitting structures connected in series according to some exemplary embodiments of the present disclosure.

Some exemplary embodiments of the present disclosure provide a light emitting diode chip and a method of manufacturing the same, and a display device. With reference to FIG. 1A, FIG. 1B and FIG. 1C, the light emitting diode chip includes a base substrate 1 and at least two light emitting structures 2 arranged on the base substrate 1. The at least two light emitting structures 2 are spaced apart and are sequentially connected in series. In the embodiments of the present disclosure, the light emitting diode chip may include a plurality of light emitting structures connected in series, so that a high-voltage chip is formed. In this way, a line current may be reduced while a power consumption of the light emitting diode remains substantially unchanged, so that a power consumption of a driving circuit may be reduced, and an overall power consumption of the light emitting diode chip may be reduced.

Here, "the at least two light emitting structures 2 are spaced apart" means that orthographic projections of the at least two light emitting structures 2 on the base substrate 1 are spaced apart.

It should be noted that, a type of the light emitting diode chip is not specifically limited in the embodiments of the present disclosure. For example, the light emitting diode chip may be Mini LED, or may be Micro LED.

For example, the base substrate 1 may be of various types, which may be selected according to actual needs. Exemplarily, the base substrate 1 may be a glass substrate, a gallium phosphide (GaP) substrate, a gallium arsenide (GaAs) substrate, a silicon substrate, a silicon carbide substrate, a sapphire substrate or the like.

In the embodiments of the present disclosure, at least one light emitting structure 2 includes: a first semiconductor layer 211 arranged on the base substrate 1, a light emitting layer 212 arranged on a side of the first semiconductor layer 211 away from the base substrate 1, a second semiconductor layer 213 arranged on a side of the light emitting layer 212 away from the base substrate 1, a first insulation layer 214 arranged on a side of the second semiconductor layer 213 away from the base substrate 1, a current spreading layer 215 arranged on a side of the first insulation layer 214 away from the base substrate 1, and a first electrode 216 arranged on a side of the current spreading layer 215 away from the base substrate 1. The inventors found through researches that a current density may be reduced if the light emitting diode is driven by a small current, and a dispersion degree of an optical performance of the light emitting diode chip may be increased accordingly. In the embodiments of the present disclosure, the current spreading layer is added to spread current, so that as a channel is provided for as many charges (such as positive charges) as possible to be transmitted to the light emitting layer, and the charges may recombine with negative charges injected from another semiconductor layer (such as an N-type layer) to emit light.

In the embodiments of the present disclosure, the at least one light emitting structure 2 includes a first via hole 217 located in the first insulation layer 214. The first electrode 216 is electrically connected to the current spreading layer 215, and the current spreading layer 215 is electrically connected to the second semiconductor layer 213 through the first via hole 217. An orthographic projection of the first via hole 217 on the base substrate 1 falls within an orthographic projection of the current spreading layer 215 on the base substrate 1, and the orthographic projection of the current spreading layer 215 on the base substrate 1 falls within an orthographic projection of the second semiconductor layer 213 on the base substrate 1.

For example, the current spreading layer 215 may be made of a transparent conductive material. In a practical manufacturing process, it is possible to first form a whole transparent conductive material layer, and then etch the transparent conductive material layer by a wet etching process, so as to form the current spreading layer 215. The inventors found through researches that during a process of etching the transparent conductive material layer by the wet etching process, there may be a problem of lateral invasion (i.e., a large amount of lateral etching), resulting in a large etching tolerance. For example, an etching tolerance on one side may reach 5 microns, so that a minimum area of the current spreading layer 215 is limited. For example, the minimum area of the current spreading layer 215 is greater than or equal to 700 square microns. In the embodiments of the present disclosure, a whole insulation layer (such as the first insulation layer 214) is manufactured first, and then the current spreading layer is evaporated after a hole is opened at a corresponding position. The etching tolerance may be small since the via hole is formed in the insulation layer by using a dry etching process. For example, the etching tolerance on one side is about 1 micron to 2 microns. An aperture of the via hole is an actual light emitting area, so that the actual light emitting area may be reduced to be, for example, less than 300 square microns, thereby the current density may be further improved. A uniformity of the light emitting diode chip at a low gray level may be further improved accordingly.

In the embodiments of the present disclosure, through the at least two light emitting structures 2 connected in series, it is possible to reduce the current in the light emitting diode chip while reaching a same luminous intensity. By providing the first insulation layer 214 and the first via hole 217, the actual light emitting area of the light emitting diode chip is reduced, an operating current density of the light emitting diode chip is improved, and an optical performance of the light emitting diode chip is optimized.

With reference to FIG. 1B and FIG. 1C, the light emitting diode chip according to the embodiments of the present disclosure may include the base substrate 1 and the at least two light emitting structures 2 arranged on the base substrate 1. For example, the base substrate 1 may be a sapphire substrate, and the light emitting structures 2 may include a first light emitting structure 21 and a second light emitting structure 22 that are connected in series.

For example, the first light emitting structure 21 and the second light emitting structure 22 may emit light respectively by a conduction of a second electrode connected to a first semiconductor layer 211 of the second light emitting structure 22 and a conduction of a first electrode 216 connected to a second semiconductor layer 213 of the first light emitting structure 21. The light emitting diode chip may be any of R (red) chip, G (green) chip, or B (blue) chip.

It may be understood that the first light emitting structure 21 and the second light emitting structure 22 may be obtained by etching a light emitting structure with a larger size than the first light emitting structure 21. Alternatively, it is also possible to etch the first light emitting structure 21 to obtain a light emitting sub-structure with a smaller size than the first light emitting structure 21.

In the above embodiments, the light emitting area of the light emitting diode chip may be reduced by opening a hole in the first insulation layer 214. In some embodiments, when the size of the light emitting diode chip is fixed, a light emission may be uneven if only two holes are opened. Therefore, it is possible to etch the light emitting diode chip to obtain more light emitting structures without reducing the operating current density of the light emitting diode chip.

According to the embodiments of the present disclosure, the light emitting diode chip may include, for example, three or more light emitting structures 2. Each light emitting structure 2 includes the first via hole 217 located in the first insulation layer 214, the first electrode 216 is electrically connected to the current spreading layer 215, and the current spreading layer 215 is electrically connected to the second semiconductor layer 213 through the first via hole 217. The orthographic projection of the first via hole 217 on the base substrate 1 falls within the orthographic projection of the current spreading layer 215 on the base substrate 1, and the orthographic projection of the current spreading layer 215 on the base substrate 1 falls within the orthographic projection of the second semiconductor layer 213 on the base substrate 1. Three or more light emitting structures 2 have three or more first via holes 217. The number of light emitting structures 2 in the light emitting diode chip may be determined according to actual needs to achieve a uniform light emission.

FIG. 2 is a partially enlarged schematic cross-sectional view of a light emitting diode chip according to some exemplary embodiments of the present disclosure.

For example, as shown in FIG. 2, the second light emitting structure 22 includes: a first semiconductor layer 211 arranged on the base substrate 1, a light emitting layer 212 arranged on a side of the first semiconductor layer 211 away from the base substrate 1, a second semiconductor layer 213 arranged on a side of the light emitting layer 212 away from the base substrate 1, a first insulation layer 214 arranged on a side of the second semiconductor layer 213 away from the base substrate 1, and a current spreading layer 215 arranged on a side of the first insulation layer 214 away from the base substrate 1.

For example, the first semiconductor layer 211 and the second semiconductor layer 213 may be an N-type layer and a P-type layer, respectively, or may also be a P-type layer and an N-type layer, respectively. The light emitting layer 212 is a quantum well layer. Under an action of current, the P-type layer injects positive charges into the quantum well layer, and the N-type layer injects negative charges into the quantum well layer. The positive charges and the negative charges are recombined to emit light in the quantum well layer.

According to the embodiments of the present disclosure, the light emitting layer 212 may include a multiple quantum well (MQW) structure, which may be, but not limited to a periodic structure in which gallium nitride (GaN) and indium gallium nitride (InGaN) are alternately arranged.

For example, the first insulation layer 214 is a PV (polyvinyl) layer. The current spreading layer 215 is an ITO (indium tin oxide) layer. The first insulation layer 214 covers the second semiconductor layer 213, and light emitted by the light emitting layer 212 is transmitted upward through the first via hole 217 in the first insulation layer 214. The light emitting area of the light emitting structure 2 may be controlled by controlling a size of the first via hole 217. In this way, the current density of the light emitting diode chip during operation may be increased in a case of low current.

A decrease of the current in the light emitting diode chip is equivalent to a decrease of the current density of the light emitting diode chip during operation, so that the dispersion degree of the optical performance of the light emitting diode chip may be increased. To solve such problem, it is possible to reduce the size of a single light emitting structure 2 in the light emitting diode chip, thereby the current density of the light emitting diode chip during operation may be improved in a case of low current, and the uniformity of light emission may be improved.

For example, as shown in FIG. 1B, it is possible to control the light emitting area of the light emitting diode chip by controlling a size of the current spreading layer 215. In one and same light emitting structure 2 of the at least one light emitting structure 2, a ratio of an area of the orthographic projection of the current spreading layer 215 on the base substrate 1 to an area of the orthographic projection of the second semiconductor layer 213 on the base substrate 1 is less than 0.1. For example, the first insulation layer 214 completely covers the second semiconductor layer 213, and the current spreading layer 215 is electrically connected to the second semiconductor layer 213 through the first via hole 217 in the first insulation layer 214. For example, the current spreading layer 215 only covers the first via hole 217, and does not cover the remaining first insulation layers 214 not opened with a hole.

According to the embodiments of the present disclosure, as shown in FIG. 1A, the light emitting diode chip further includes, for example, a second reflection layer 220 located on a side of the current spreading layer 215 away from the base substrate 1. The second reflection layer 220 includes a Bragg reflector. The second reflection layer 220 is used to enhance a brightness of the light emitting diode chip and to perform an insulated encapsulation on a PN junction.

Optionally, the second reflection layer 220 is, for example, a distributed Bragg reflector (DBR), or a composite layer of DBR and PV. The DBR layer is a periodic structure formed by an alternate arrangement of two materials with different refractive indexes, and an optical thickness of each layer of materials arranged alternately is one fourth of a central reflection wavelength. In an example, the materials with different refractive indexes that form the DBR layer may be silicon dioxide (SiOz) and titanium dioxide (TiOz), that is, silicon dioxide and titanium dioxide are alternately arranged to form the DBR layer. In other examples, the materials with different refractive indexes that form the DBR layer may also be other materials.

According to the embodiments of the present disclosure, as shown in FIG. 1A, the light emitting diode chip further includes, for example, a second via hole 221 located in the second reflection layer 220, and the first electrode 216 is electrically connected to the current spreading layer 215 through the second via hole 221. The current spreading layer 215 is in direct contact with the second semiconductor layer 213 to achieve an electrical connection through the first via hole 217. The first electrode 216 is electrically connected to the second semiconductor layer 213 through the current spreading layer 215.

According to the embodiments of the present disclosure, as shown in FIG. 1A, the light emitting diode chip further includes, for example, a second electrode 222 and a third via hole 223. The third via hole is located in the second reflection layer 220. The second electrode 222 is electrically connected to the first semiconductor layer 211 of one light emitting structure 2 through the third via hole 223, and an orthographic projection of the third via hole 223 on the base substrate 1 is spaced apart from the orthographic projection of the first via hole 217 on the base substrate 1. The second electrode 222 is in direct contact with the first semiconductor layer 211 to achieve an electrical connection through the third via hole 223.

For example, the first electrode 216 and the second electrode 222 are electrically connected to a first P-type layer and a first N-type layer between two adjacent independent light emitting structures, respectively. A second P-type layer and a second N-type layer between the two adjacent independent light emitting structures are electrically connected through a metal part, so that a series electrical connection path between the two adjacent independent light emitting structures may be achieved, and the two adjacent independent light emitting structures may emit light at the same current density.

In some exemplary embodiments of the present disclosure, the light emitting diode chip may be a Mini LED chip. Mini LED may be driven by a thin film transistor, like an active matrix, or may be driven by a driving IC, like a passive matrix. For example, an LED backlight source may be driven by a thin film transistor. Specifically, the Mini LED chip may be applied to an LCD display panel to form a display screen.

It should be noted that the LED chip is represented by a rectangular box in FIG. 1C. However, it may be understood that the LED chip in the embodiments of the present disclosure is not limited to a rectangle, but may be in other shapes such as a circle, a polygon, etc.

According to the embodiments of the present disclosure, as shown in FIG. 1B, the light emitting diode chip further includes a bridging conductive portion 218 arranged on a side of the current spreading layer 215 away from the base substrate 1. The bridging conductive portion 218 includes a first part 2181 and a second part 2182. The at least two light emitting structures 2 include the first light emitting structure 21 and the second light emitting structure 22 that are adjacent to each other, and the first light emitting structure 21 and the second light emitting structure 22 are electrically connected through the bridging conductive portion 218. The first part 2181 of the bridging conductive portion 218 is electrically connected to the second semiconductor layer 213 of the second light emitting structure 22, and the second part 2182 of the bridging conductive portion 218 is electrically connected to the first semiconductor layer 211 of the first light emitting structure 21. The first light emitting structure 21 and the second light emitting structure 22 are PN junctions that emit light independently. Through the bridging conductive portion 218, a P-type layer and an N-type layer of two adjacent independent light emitting structures, namely the first light emitting structure 21 and the second light emitting structure 22, may be electrically connected.

In the embodiments of the present disclosure, an orthographic projection of the first part 2181 of the bridging conductive portion on the base substrate 1 falls within the orthographic projection of the second semiconductor layer 213 of the first light emitting structure on the base substrate 1, and an orthographic projection of the second part 2182 of the bridging conductive portion on the base substrate 1 falls within the orthographic projection of the first semiconductor layer 211 of the second light emitting structure on the base substrate 1.

In the above embodiments, it is possible to etch the light emitting diode chip to obtain three or more light emitting structures 2 to achieve a uniform light emission of the light emitting diode chip. It is also possible to provide a plurality of holes in one light emitting structure 2 to achieve the uniform light emission of the light emitting diode chip without increasing the number of light emitting structures, so that a process difficulty may be reduced.

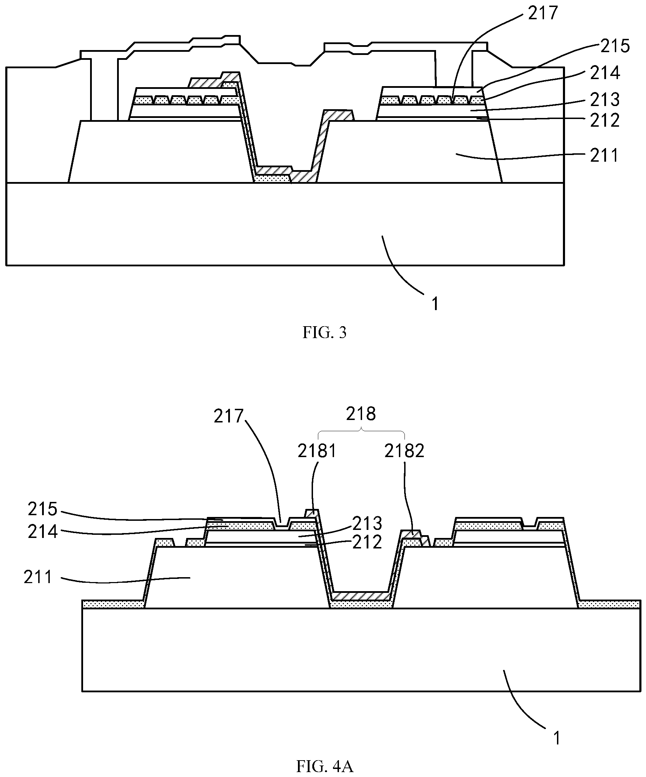

FIG. 3 is a schematic cross-sectional view of a light emitting diode chip according to some other exemplary embodiments of the present disclosure.

According to the embodiments of the present disclosure, as shown in FIG. 3, in one and same light emitting structure 2 of the at least one light emitting structure 2, a plurality of first via holes 217 are provided in the first insulation layer 214, and the current spreading layer 215 is electrically connected to the second semiconductor layer 213 through the plurality of first via holes 217. Orthographic projections of the plurality of first via holes 217 on the base substrate 1 all fall within the orthographic projection of the current spreading layer 215 on the base substrate 1. Compared with providing one first via hole 217 in the first insulation layer 214, providing a plurality of first via holes 217 in the first insulation layer 214 may disperse the current density in a single first via hole 217, so as to avoid a breakdown of the current spreading layer 215 inside the first via hole 217 due to an excessive current density in a single first via hole 217, then an ESD (Electro-Static discharge) performance of the light emitting diode chip may be improved. Moreover, the plurality of first via holes 217 provide a plurality of light emission channels, and a uniform light emission of the light emitting diode chip may be achieved in a case of a particular arrangement of the plurality of first via holes 217.

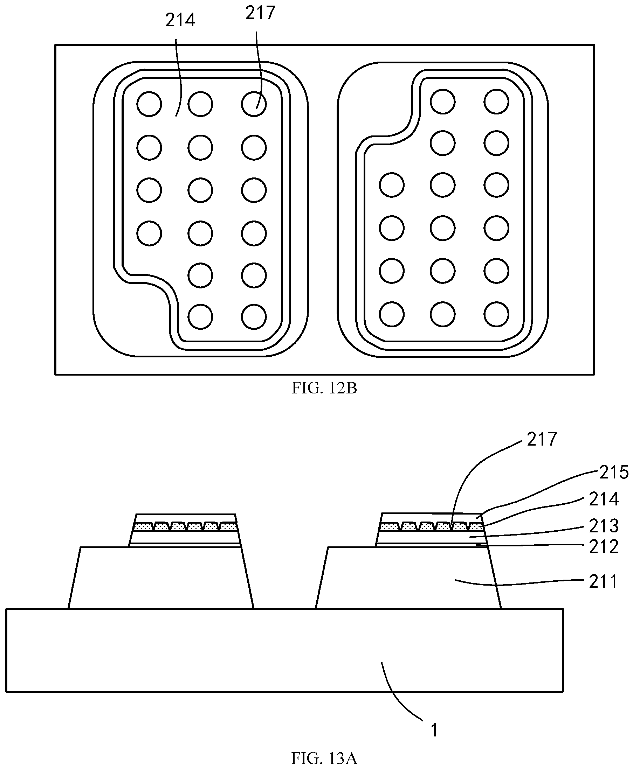

For example, as shown in FIG. 12B, the arrangement of the plurality of first via holes 217 is as follows. in one and same light emitting structure 2 of the at least one light emitting structure 2, the orthographic projections of the plurality of first via holes 217 on the base substrate 1 are arranged in an array in a first direction and a second direction intersecting with the first direction. The first direction and the second direction may be, for example, orthogonal to each other, and the plurality of first via holes 217 are arranged in rows and columns that are perpendicular to each other, so that the light emitting diode chip may emit light neatly and evenly.

For example, in terms of a connection manner, as shown in FIG. 3, the orthographic projection of the first part 2181 of the bridging conductive portion 218 on the base substrate 1 overlaps at least partially with the orthographic projection of the current spreading layer 215 of the first light emitting structure 21 on the base substrate 1. The first part 2181 of the bridging conductive portion 218 is in direct contact with the current spreading layer 215 to achieve an electrical connection between the bridging conductive portion 218 and the P-type layer of the first light emitting structure 21.

For example, the orthographic projection of the first via hole 217 on the base substrate 1 overlaps at least partially with the orthographic projection of the first part 2181 of the bridging conductive portion 218 on the base substrate 1. The current spreading layer 215 is electrically connected to the second semiconductor layer 213 of the first light emitting structure 21 through the first via hole 217, the first part 2181 of the bridging conductive portion 218 is in direct contact with the current spreading layer 215 inside the first via hole 217, and the first part 2181 of the bridging conductive portion 218 at least partially covers the current spreading layer 215 inside the first via hole 217. A charge transfer rate of the bridging conductive portion 218 is greater than a charge transfer rate of the current spreading layer 215, so that the bridging conductive portion 218 covering the current spreading layer 215 inside the first via hole 217 may timely transfer charges in the current spreading layer 215 inside the first via hole 217, then accumulated charges in the current spreading layer 215 inside the first via hole 217 may be reduced, and the ESD performance of the light emitting diode chip may be improved.

For example, the orthographic projection of at least one of the plurality of first via holes 217 on the base substrate 1 overlaps at least partially with the orthographic projection of the first part 2181 of the bridging conductive portion 218 on the base substrate 1. When a plurality of first via holes 217 are provided in the first insulation layer 214, the orthographic projection of at least one first via hole 217 on the base substrate 1 overlaps at least partially with the orthographic projection of the first part 2181 of the bridging conductive portion 218 on the base substrate 1, so as to achieve an electrical connection between the bridging conductive portion 218 and the second semiconductor layer 213.

For example, as shown in FIG. 3, the orthographic projection of the first via hole 217 on the base substrate 1 falls within an orthographic projection of the second via hole 221 on the base substrate 1. When a plurality of first via holes 217 are provided in the first insulation layer 214, the orthographic projection of at least one first via hole 217 on the base substrate 1 falls within the orthographic projection of the second via hole 221 on the base substrate 1, so as to achieve an electrical connection between the first electrode 216 and the second semiconductor layer 213.

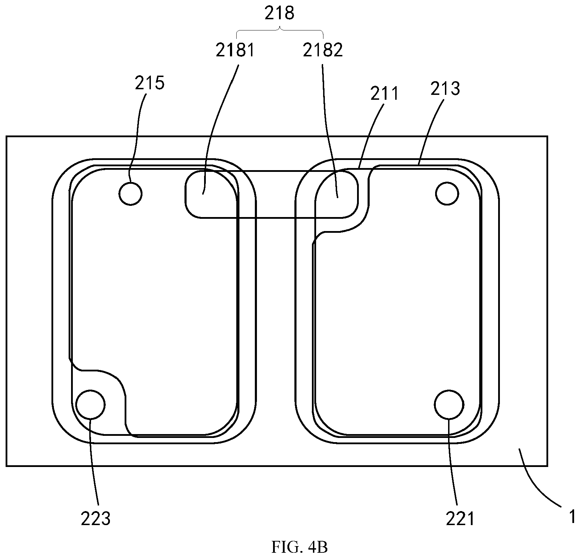

FIG. 4A is a cross-sectional view of a connection structure between the bridging conductive portion and the first light emitting structure according to some other exemplary embodiments of the present disclosure. FIG. 4B is a plan view of a connection structure between the bridging conductive portion and the first light emitting structure according to some other exemplary embodiments of the present disclosure.

In some embodiments, the bridging conductive portion 218 is manufactured directly after the current spreading layer 215 is manufactured, and a reflectivity of the bridging conductive portion 218 is less than a reflectivity of the second reflection layer 220 manufactured subsequently, which may cause a decrease in the brightness of the light emitting diode chip. In order to avoid the decrease in the brightness of the light emitting diode chip, the first part 2181 of the bridging conductive portion 218 may not cover the first via hole 217 so as not to block the light emitted from the first via hole 217.

With reference to FIG. 4A and FIG. 4B in combination, for example, the orthographic projection of the first via hole 217 on the base substrate 1 does not overlap with the orthographic projection of the first part 2181 of the bridging conductive portion 218 on the base substrate 1. The first part 2181 of the bridging conductive portion 218 does not cover the first via hole 217, and is in direct contact with the current spreading layer 215 not located inside the first via hole 217, so as to achieve an electrical connection.

In the above embodiments, the uniformity of the light emission of the light emitting structure 2 is improved by providing a plurality of first via holes 217 in one light emitting structure 2. In order to achieve a higher operating current density of the light emitting diode chip, each first via hole 217 need to have a size less than a size threshold.

For example, in one and same light emitting structure 2 of the at least one light emitting structure 2, a ratio of an area of the orthographic projection of each of the plurality of first via holes 217 on the base substrate 1 to an area of the orthographic projection of the second semiconductor layer 213 on the base substrate 1 is less than 0.1; and/or in one and same light emitting structure 2 of the at least one light emitting structure 2, the orthographic projection of the current spreading layer 215 on the base substrate 1 substantially coincides with the orthographic projection of the second semiconductor layer 213 on the base substrate 1. Since the light emitting structure 2 emits light through the first via hole 217, the size of the current spreading layer 215 does not affect the light emitting area, thus a size of the current spreading layer 215 may be designed to be substantially same as a size of the second semiconductor layer 213, so that the first part 2181 of the bridging conductive portion 218 does not cover the first via hole 217 while being connected to the current spreading layer 215, thereby avoiding the decrease in the brightness of the light emitting diode chip caused by the reflectivity of the bridging conductive portion 218 being less than reflectivity of the subsequently manufactured second reflection layer 220.

In some embodiments, the first part 2181 of the bridging conductive portion 218 does not cover the first via hole 217, thereby avoiding the decrease in the brightness of the light emitting diode chip. The charge transfer rate of the bridging conductive portion 218 is greater than the charge transfer rate of the current spreading layer 215, thus a charge accumulation in the current spreading layer 215 caused by a difference in the charge transfer rates of the two may be reduced by designing a shape of the bridging conductive portion 218 and a connection manner between the bridging conductive portion 218 and the current spreading layer 215, so as to improve the ESD performance of the light emitting diode chip.

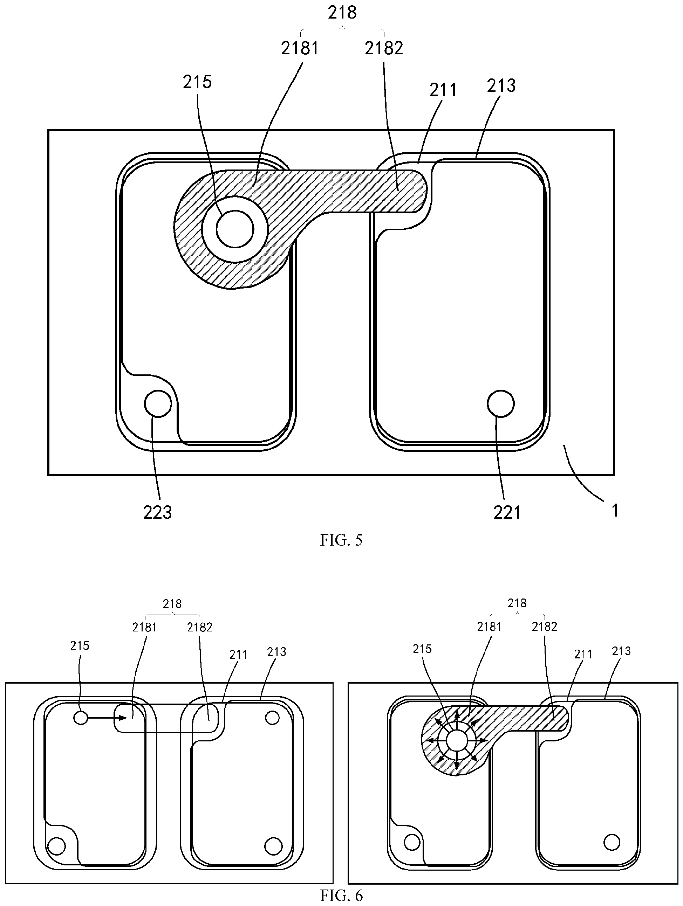

FIG. 5 is a plan view of a connection structure between the bridging conductive portion and the first light emitting structure according to still other exemplary embodiments of the present disclosure.

According to the embodiments of the present disclosure, as shown in FIG. 5, the orthographic projection of the first part 2181 of the bridging conductive portion 218 on the base substrate 1 is spaced apart from the orthographic projection of the first via hole 217 on the base substrate 1, and an orthographic projection of a partial region of the first part 2181 of the bridging conductive portion 218 on the base substrate 1 surrounds the orthographic projection of the first via hole 217 on the base substrate 1. The first part 2181 of the bridging conductive portion 218 does not cover the first via hole 217, but surrounds a periphery of the first via hole 217, so that the charges in the current spreading layer 215 inside the first via hole 217 may be timely transferred, the accumulated charges in the current spreading layer 215 may be reduced, and the ESD performance of the light emitting diode chip may be improved. Moreover, since the first part 2181 of the bridging conductive portion 218 does not cover the first via hole 217, thus it may be ensured that the brightness of the light emitting diode chip does not decrease.

For example, as shown in FIG. 5, the orthographic projection of the first via hole 217 on the base substrate 1 is a circle, and the orthographic projection of the partial region of the first part 2181 of the bridging conductive portion 218 on the base substrate 1 is a ring. The ring formed by the partial region of the first part 2181 of the bridging conductive portion 218 is substantially concentric with the circle formed by the first via hole 217. By combining the first via hole 217 whose orthographic projection on the base substrate 1 is the circle with the first part 2181 of the bridging conductive portion 218 whose orthographic projection on the base substrate 1 is the ring, the charges in the current spreading layer 215 inside the first via hole 217 may be transferred rapidly.

It may be understood that the shape of the orthographic projection of the first via hole 217 on the base substrate 1 may be other than a circle, such as a square, a rhombus, an ellipse, etc., and an inner contour of the shape of the orthographic projection of the first part 2181 of the bridging conductive portion 2181 on the base substrate 1 may also be another shape corresponding to the shape of the orthographic projection of the first via hole 217 on the base substrate 1.

FIG. 6 is a comparative plan view of connection structures between the bridging conductive portion and the first light emitting structure according to two exemplary embodiments of the present disclosure.

According to the embodiments of the present disclosure, as shown in FIG. 6, in a solution of combining the first via hole 217 whose orthographic projection on the base substrate 1 is the circle with the first part 2181 of the bridging conductive portion 218 whose orthographic projection on the base substrate 1 is the ring, the charges may be uniformly transferred from a periphery of the first via hole 217 to the partial region of the first part 2181 of the bridging conductive portion 218, and a charge transfer efficiency is superior to a charge transfer efficiency in a solution of transferring charges from the first via hole 217 to the first part 2181 of the bridging conductive portion 218 in a single direction.

In the above embodiments, the first part 2181 of the bridging conductive portion 218 may not cover the first via hole 217, so as to avoid the decrease in the brightness of the light emitting diode chip caused by the reflectivity of the first part 2181 of the bridging conductive portion 218 being less than the reflectivity of the second reflection layer 220. It is also possible to provide a metal layer with high reflectivity at a lower part of the first via hole 217 inside the first via hole 217 to ensure that the brightness of the light emitting diode chip does not decrease and improve the ESD performance of the light emitting diode chip.

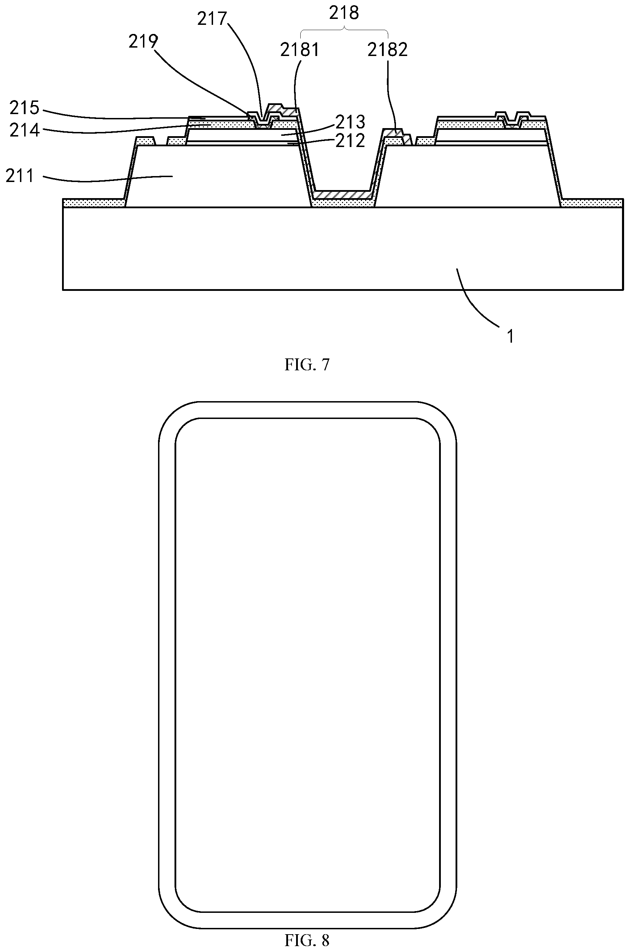

FIG. 7 is a cross-sectional view of a connection structure between the bridging conductive portion and the first light emitting structure according to still other exemplary embodiments of the present disclosure.

According to the embodiments of the present disclosure, as shown in FIG. 7, the light emitting diode chip further includes, for example, a first reflection layer 219 located between the first insulation layer 214 and the current spreading layer 215. A light reflectivity of the first reflection layer 219 is greater than the light reflectivity of the bridging conductive portion 218, and the orthographic projection of the first via hole 217 on the base substrate 1 falls within an orthographic projection of the first reflection layer 219 on the base substrate 1.

For example, the first reflection layer 219 is, for example, a metallic silver with high reflectivity. The first reflection layer 219 may effectively increase a charge accumulation area of the current spreading layer 215 inside the first via hole 217, for example, a radius of the charge accumulation area may be increased from 8 microns to 10 microns, thereby improving the ESD performance of the light emitting diode chip.

For example, the orthographic projection of the first reflection layer 219 on the base substrate 1 overlaps at least partially with the orthographic projection of the first part 2181 of the bridging conductive portion 218 on the base substrate 1. The first reflection layer 219 is arranged in the first via hole 217 and partially extends out of the first via hole 217, so as to cover the first via hole 217 but not cover the remaining first insulation layers 214 not opened with a hole. The current spreading layer 215 covers the first reflection layer 219 and the first insulation layer 214 not covered by the first reflection layer 219. The current spreading layer 215 covers the first reflection layer 219, which may avoid a migration of the first reflection layer 219. Since the light reflectivity of the first reflection layer 219 is greater than the light reflectivity of the bridging conductive portion 218, the first part 2181 of the bridging conductive portion 218 may cover the first via hole 217, thereby improving the ESD performance of the light emitting diode chip.

Some exemplary embodiments of the present disclosure further provide a display device. FIG. 8 is a schematic diagram of a display device according to some exemplary embodiments of the present disclosure. Referring to FIG. 8, the display device includes the light emitting diode chip as described above.

The display device may be any product or component with a display function. For example, the display device may be a smart phone, a portable phone, a navigation apparatus, a television (TV), a vehicle stereo, a laptop computer, a tablet computer, a portable multimedia player (PMP), a personal digital assistant (PDA), and so on.

For example, in some Mini LED display modules applying the light emitting diode chip of the embodiments of the present disclosure, the current in the light emitting diode chip is reduced, so that a power consumption and a cost of the Mini LED display module may be reduced. In addition, a Cu thickness of the base substrate may be reduced, and the process difficulty may be lowered. In a case that the existing process difficulty is unchanged, the use of high-voltage light emitting diode chip ensures a yield of the display module.

It should be understood that the display device according to some exemplary embodiments of the present disclosure has all the characteristics and advantages of the above-mentioned light emitting diode chip. For these characteristics and advantages, reference may be made to the above descriptions of the light emitting diode chip, which will not be repeated here.

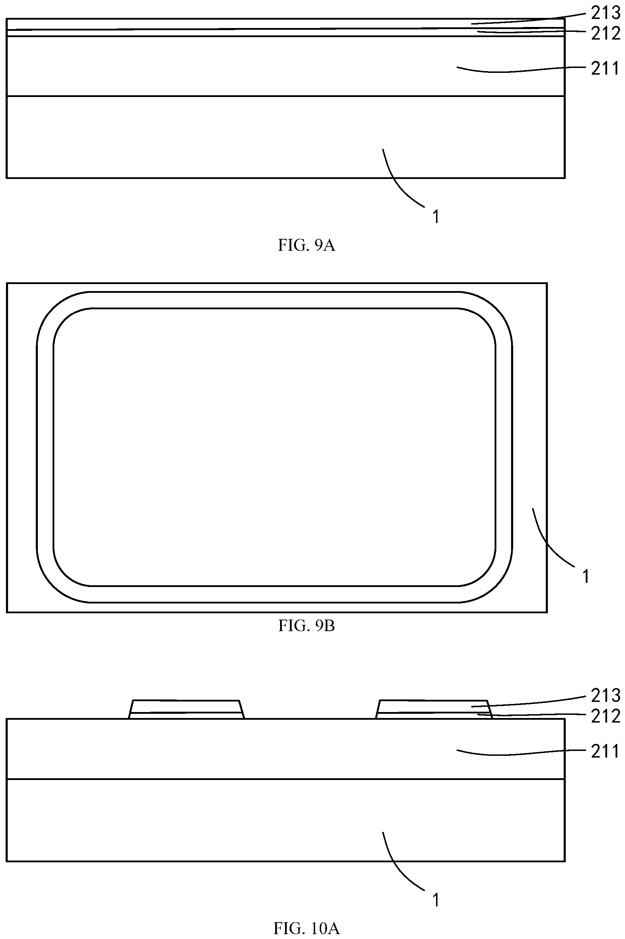

Some other exemplary embodiments of the present disclosure further provide a method of manufacturing a light emitting diode chip. FIGS. 9A to 17A are schematic cross-sectional views of structures that are formed after some steps of a method of manufacturing a light emitting diode chip according to some exemplary embodiments of the present disclosure are performed, respectively. FIGS. 9B to 17B are schematic plan views of structures that are formed after some steps of the method of manufacturing the light emitting diode chip according to some exemplary embodiments of the present disclosure are performed, respectively.

Referring to FIG. 9A to FIG. 17B, the method of manufacturing the light emitting diode chip includes: a base substrate 1 is provided, and at least two light emitting structures 2 are formed on the base substrate 1. The at least two light emitting structures 2 are spaced apart and are sequentially connected in series. Forming at least two light emitting structures 2 on the base substrate 1 includes: a first semiconductor layer 211 is formed on the base substrate 1, a light emitting layer 212 is formed on a side of the first semiconductor layer 211 away from the base substrate 1, a second semiconductor layer 213 is formed on a side of the light emitting layer 212 away from the base substrate 1, and a first insulation layer 214 is formed on a side of the second semiconductor layer 213 away from the base substrate 1. Through a dry etching process, a first via hole 217 is formed in the first insulation layer 214, a current spreading layer 215 is formed on a side of the first insulation layer 214 away from the base substrate 1, and a first electrode 216 is formed on a side of the current spreading layer 215 away from the base substrate 1. The first electrode 216 is electrically connected to the current spreading layer 215, and the current spreading layer 215 is electrically connected to the second semiconductor layer 213 through a first via hole 217. An orthographic projection of the first via hole 217 on the base substrate 1 falls within an orthographic projection of the current spreading layer 215 on the base substrate 1, and the orthographic projection of the current spreading layer 215 on the base substrate 1 falls within an orthographic projection of the second semiconductor layer 213 on the base substrate 1.

For example, each layer of the light emitting diode chip may be manufactured by combining metal-organic chemical vapor deposition (MOCVD) with etching.

Specifically, referring to FIG. 9A and FIG. 9B, the first semiconductor layer 211, the light emitting layer 212 and the second semiconductor layer 213 are sequentially deposited on the base substrate 1 to obtain a PN junction deposited on the base substrate 1.

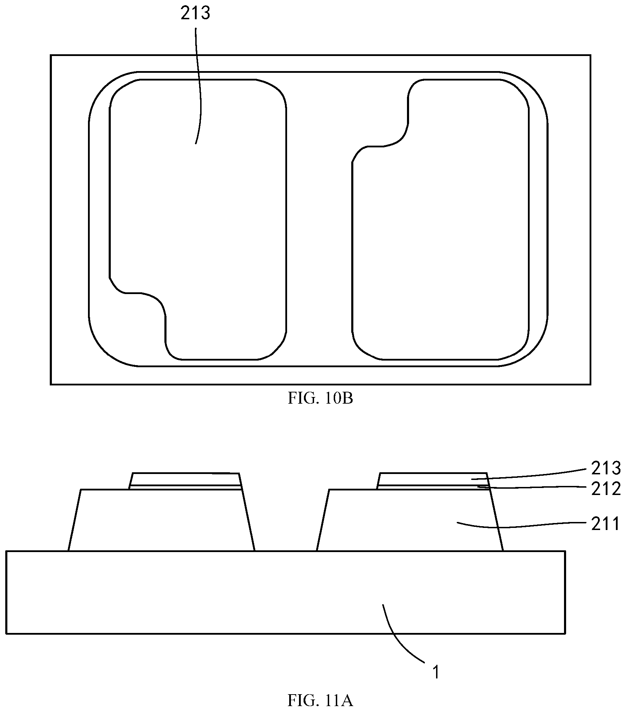

Referring to FIG. 10A and FIG. 10B, the second semiconductor layer 213 and the light emitting layer 212 are etched to obtain basic shapes of the second semiconductor layer 213 and the light emitting layer 212.

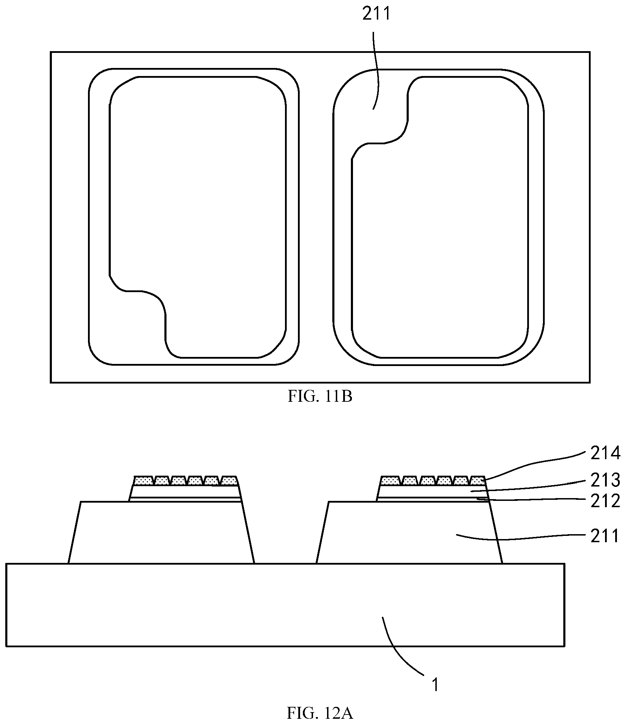

Referring to FIG. 11A and FIG. 11B, the first semiconductor layer 211 is further etched to obtain two independent PN junctions on the base substrate 1.

Referring to FIG. 12A and FIG. 12B, a deposition and an etching are performed on the second semiconductor layer 213 of each PN junction to obtain the first insulation layer 214, and the first insulation layer 214 is etched to obtain a plurality of first via holes 217 whose orthographic projections are arranged in an array in the first direction and the second direction.

In the embodiments of the present disclosure, it is possible to control a light emitting area of the light emitting structure 2 by controlling a size of the first via hole 217. In this way, a current density of the light emitting diode chip during operation may be increased in a case of low current. Compared with providing one first via hole 217 in the first insulation layer 214, providing a plurality of first via holes 217 in the first insulation layer 214 may disperse the current density in a single first via hole 217, so as to avoid a breakdown of the current spreading layer 215 inside the first via hole 217 due to an excessive current density in a single first via hole 217, then an ESD (Electro-Static discharge) performance of the light emitting diode chip may be improved. Moreover, the plurality of first via holes 217 provide a plurality of light emission channels, and a uniform light emission of the light emitting diode chip may be achieved in a case of a particular arrangement of the plurality of first via holes 217.

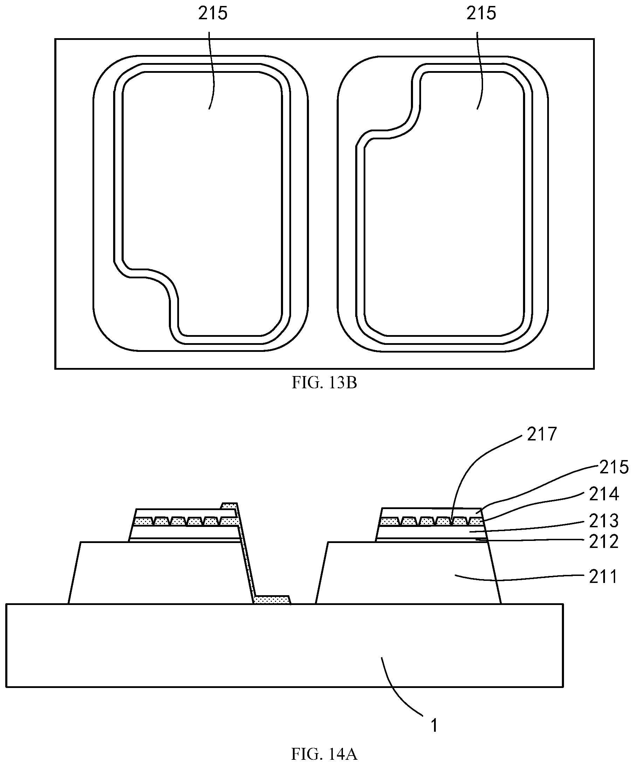

Referring to FIG. 13A and FIG. 13B, the current spreading layer 215 is evaporated on the first insulation layer 214 that has been opened with a hole, so as to obtain a first light emitting structure 21 and a second light emitting structure 22.

In the embodiments of the present disclosure, the current spreading layer 215 is added to spread current, so that a channel is provided for as many charges (such as positive charges) as possible to be transmitted from the second semiconductor layer 213 (such as P-type layer) to the light emitting layer 212, and may be recombined with negative charges injected from the first semiconductor layer 211 (such as N-type layer) to emit light.

Specifically, for example, the first insulation layer 214 is manufactured by dry etching. After the first insulation layer 214 is manufactured, a hole is opened in the first insulation layer 214 to obtain the first via hole 217. Then, the current spreading layer 215 is evaporated inside the first via hole 217, thereby avoiding a problem of lateral invasion when manufacturing the current spreading layer 215 in the wet etching process. Since the first insulation layer 214 is manufactured using the dry etching process, an etching tolerance is small (such as 1~2 µm on one side). An aperture of the first via hole 217 is an actual light emitting area, then the actual light emitting area may be greatly reduced (for example, the light emitting area is less than 300 µm²), so that the current density of the light emitting diode chip during operation may be greatly improved, and the uniformity of the light emission of the light emitting diode chip may be further improved.

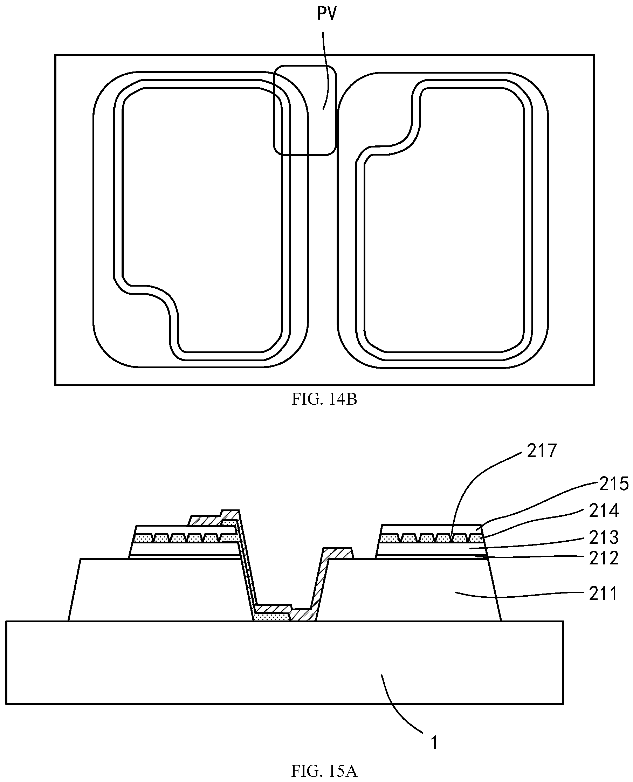

Referring to FIG. 14A and FIG. 14B, an insulation layer is deposited in AA region.

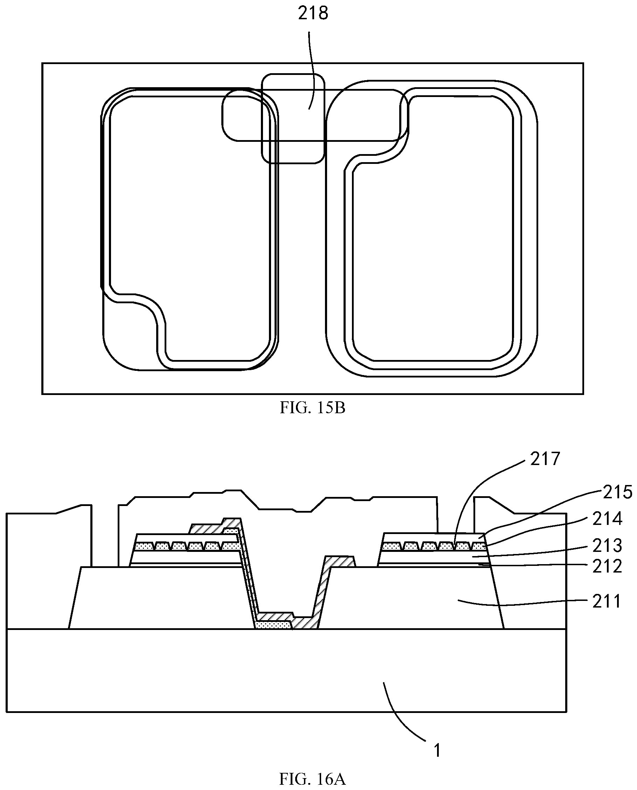

Referring to FIG. 15A and FIG. 15B, a bridging conductive portion 218 is deposited in BB region. The insulation layer in the AA region separates the bridging conductive portion 218 in the BB region from the first light emitting structure 21, and a first part 2181 of the bridging conductive portion 218 is in contact with the current spreading layer 215 of the first light emitting structure 21 to achieve an electrical connection between the first part 2181 of the bridging conductive portion 218 and the second semiconductor layer 213 of the first light emitting structure 21. A second part 2182 of the bridging conductive portion 218 is in contact with the first semiconductor layer 211 of the second light emitting structure 22 to achieve an electrical connection between the second part 2182 of the bridging conductive portion 218 and the first semiconductor layer 211 of the second light emitting structure 22. Therefore, the bridging conductive portion 218 achieves a series electrical connection between the first light emitting structure 21 and the second light emitting structure 22.

In the embodiments of the present disclosure, the first part 2181 of the bridging conductive portion 218 may cover a part of the plurality of first via holes 217, or cover no first via hole 217. The first part 2181 of the bridging conductive portion 218 does not cover the first via hole 217, thus a decrease in a brightness of the light emitting diode chip may be avoided. By designing a shape of the bridging conductive portion 218 and a connection manner between the bridging conductive portion 218 and the current spreading layer 215, a charge accumulation in the current spreading layer 215 caused by a difference in charge transfer rates of the two may be reduced, and the ESD performance of the light emitting diode chip may be improved.

In the embodiments of the present disclosure, the light emitting diode chip may include the first light emitting structure 21 and the second light emitting structure 22 connected in series, so that a high-voltage chip is formed. In this way, a line current may be reduced while a power consumption of the light emitting diode remains substantially unchanged, so that a power consumption of a driving circuit may be reduced, and an overall power consumption of the light emitting diode chip may be reduced.

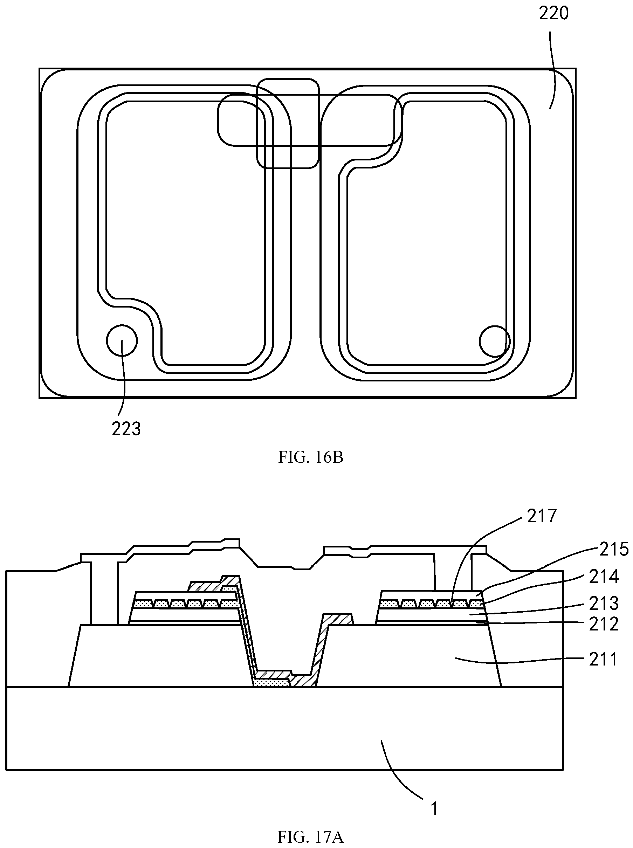

Referring to FIG. 16A and FIG. 16B, a second reflection layer 220 is deposited on the first light emitting structure 21 and the second light emitting structure 22 that are electrically connected in series, and the second reflection layer 220 is etched to obtain a second via hole 221 in communication with the current spreading layer 215 of the second light emitting structure 22, and the second reflection layer 220 is etched to obtain a third via hole 223 in communication with the first semiconductor layer 211 of the first light emitting structure 21. The second reflection layer 220 is used to enhance the brightness of the light emitting diode chip and to perform an insulate encapsulation on the PN junction.

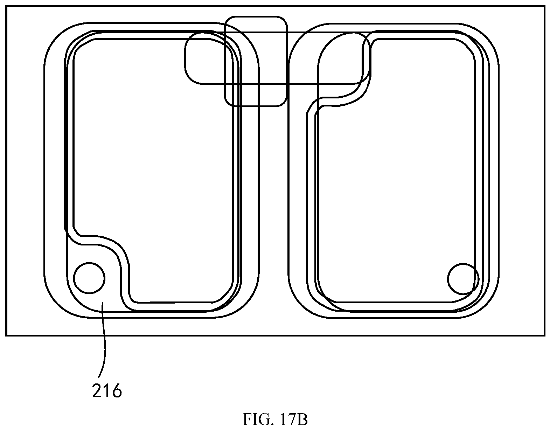

Referring to FIG. 17A and FIG. 17B, the first electrode 216 is deposited in the second via hole 221, and a second electrode 222 is deposited in the third via hole 223, so as to obtain a light emitting diode chip according to some other embodiments of the present disclosure.

It should be noted that some steps in the above-mentioned manufacturing method may be performed separately or in combination, and may be performed in parallel or sequentially, and may not be limited to the specific operation sequence shown in the drawings.

As used here, the terms "substantially", "roughly", "approximately" and other similar terms are used as terms of approximation rather than as terms of degree, and they are intended to explain an inherent deviation of a measured or calculated value that will be recognized by those ordinary skilled in the art. Taking into account a process fluctuation, a measurement problem, and an error related to a measurement of a specific quantity (that is, a limitation of a measurement system), the terms " roughly " or "approximately" used here includes a stated value and means that a specific value determined by those ordinary skilled in the art is within an acceptable range of deviation. For example, " roughly" may mean being within one or more standard deviations, or within ±10% or ±5% of the stated value.

Although some embodiments according to the general inventive concept of the present disclosure have been illustrated and described, it should be understood by those ordinary skilled in the art that those embodiments may be changed without departing from the principle and spirit of the general inventive concept of the present disclosure, and the scope of the present disclosure is defined by the claims and their equivalents.

## Claims

1. A light emitting diode chip, comprising:
a base substrate; and
at least two light emitting structures arranged on the base substrate, wherein orthographic projections of the at least two light emitting structures on the base substrate are spaced apart, and the at least two light emitting structures are sequentially connected in series,
wherein at least one of the light emitting structures comprises:
a first semiconductor layer arranged on the base substrate;
a light emitting layer arranged on a side of the first semiconductor layer away from the base substrate;
a second semiconductor layer arranged on a side of the light emitting layer away from the base substrate;
a first insulation layer arranged on a side of the second semiconductor layer away from the base substrate;
a current spreading layer arranged on a side of the first insulation layer away from the base substrate; and
a first electrode arranged on a side of the current spreading layer away from the base substrate,
wherein the at least one light emitting structure comprises a first via hole located in the first insulation layer, the first electrode is electrically connected to the current spreading layer, and the current spreading layer is electrically connected to the second semiconductor layer through the first via hole; and
wherein an orthographic projection of the first via hole on the base substrate falls within an orthographic projection of the current spreading layer on the base substrate, and the orthographic projection of the current spreading layer on the base substrate falls within an orthographic projection of the second semiconductor layer on the base substrate.

2. The light emitting diode chip according to claim 1, wherein in one and same light emitting structure of the at least one light emitting structure, a plurality of first via holes are arranged in the first insulation layer, and the current spreading layer is electrically connected to the second semiconductor layer through the plurality of first via holes; and
wherein orthographic projections of the plurality of first via holes on the base substrate fall within the orthographic projection of the current spreading layer on the base substrate.

3. The light emitting diode chip according to claim 1 or 2, wherein the light emitting diode chip further comprises a bridging conductive portion arranged on a side of the current spreading layer away from the base substrate, and the bridging conductive portion comprises a first part and a second part; and
wherein the at least two light emitting structures comprise a first light emitting structure and a second light emitting structure that are adjacent to each other, the first light emitting structure and the second light emitting structure are electrically connected through the bridging conductive portion, the first part of the bridging conductive portion is electrically connected to the second semiconductor layer of the first light emitting structure, the second part of the bridging conductive portion is electrically connected to the first semiconductor layer of the second light emitting structure, an orthographic projection of the first part of the bridging conductive portion on the base substrate falls within an orthographic projection of the second semiconductor layer of the first light emitting structure on the base substrate, and an orthographic projection of the second part of the bridging conductive portion on the base substrate falls within an orthographic projection of the first semiconductor layer of the second light emitting structure on the base substrate.

4. The light emitting diode chip according to claim 3, wherein the orthographic projection of the first part of the bridging conductive portion on the base substrate overlaps at least partially with an orthographic projection of the current spreading layer of the first light emitting structure on the base substrate.

5. The light emitting diode chip according to claim 1, wherein the orthographic projection of the first via hole on the base substrate overlaps at least partially with the orthographic projection of the first part of the bridging conductive portion on the base substrate.

6. The light emitting diode chip according to claim 2, wherein the orthographic projection of at least one of the plurality of first via holes on the base substrate overlaps at least partially with the orthographic projection of the first part of the bridging conductive portion on the base substrate.

7. The light emitting diode chip according to claim 1, wherein the orthographic projection of the first via hole on the base substrate does not overlap with the orthographic projection of the first part of the bridging conductive portion on the base substrate.

8. The light emitting diode chip according to claim 7, wherein the orthographic projection of the first part of the bridging conductive portion on the base substrate is spaced apart from the orthographic projection of the first via hole on the base substrate, and an orthographic projection of a partial region of the first part of the bridging conductive portion on the base substrate surrounds the orthographic projection of the first via hole on the base substrate.

9. The light emitting diode chip according to claim 5, 7 or 8, wherein the light emitting diode chip further comprises a first reflection layer between the first insulation layer and the current spreading layer, a light reflectivity of the first reflection layer is greater than a light reflectivity of the bridging conductive portion, and the orthographic projection of the first via hole on the base substrate falls within an orthographic projection of the first reflection layer on the base substrate.

10. The light emitting diode chip according to any one of claims 1, 2 and 4 to 8, wherein the light emitting diode chip further comprises a second reflection layer on a side of the current spreading layer away from the base substrate, and the second reflection layer comprises a Bragg reflector.

11. The light emitting diode chip according to claim 10, wherein the light emitting diode chip further comprises a second via hole in the second reflection layer, the first electrode is electrically connected to the current spreading layer through the second via hole, and the orthographic projection of the first via hole on the base substrate falls within an orthographic projection of the second via hole on the base substrate.

12. The light emitting diode chip according to claim 2, wherein in one and same light emitting structure of the at least one light emitting structure, the orthographic projections of the plurality of first via holes on the base substrate are arranged in an array in a first direction and a second direction intersecting with the first direction.

13. The light emitting diode chip according to claim 1, wherein in one and same light emitting structure of the at least one light emitting structure, a ratio of an area of the orthographic projection of the current spreading layer on the base substrate to an area of the orthographic projection of the second semiconductor layer on the base substrate is less than 0.1.

14. The light emitting diode chip according to claim 2, wherein in one and same light emitting structure of the at least one light emitting structure, a ratio of an area of the orthographic projection of each of the plurality of first via holes on the base substrate to an area of the orthographic projection of the second semiconductor layer on the base substrate is less than 0.1; and/or
wherein in one and same light emitting structure of the at least one light emitting structure, the orthographic projection of the current spreading layer on the base substrate substantially coincides with the orthographic projection of the second semiconductor layer on the base substrate.

15. The light emitting diode chip according to claim 8, wherein the orthographic projection of the first via hole on the base substrate is a circle, the orthographic projection of the partial region of the first part of the bridging conductive portion on the base substrate is a ring, and the ring-shaped partial region of the first part of the bridging conductive portion is substantially concentric with the circular first via hole.

16. The light emitting diode chip according to claim 9, wherein the orthographic projection of the first reflection layer on the base substrate overlaps at least partially with the orthographic projection of the first part of the bridging conductive portion on the base substrate.

17. The light emitting diode chip according to claim 11, wherein the light emitting diode chip further comprises a second electrode and a third via hole, the third via hole is located in the second reflection layer, the second electrode is electrically connected to the first semiconductor layer of one light emitting structure through the third via hole, and an orthographic projection of the third via hole on the base substrate is spaced apart from the orthographic projection of the first via hole on the base substrate.

18. The light emitting diode chip according to claim 1, wherein the light emitting diode chip comprises three or more light emitting structures, each of the light emitting structures comprises the first via hole located in the first insulation layer, the first electrode is electrically connected to the current spreading layer, and the current spreading layer is electrically connected to the second semiconductor layer through the first via hole; and
wherein the orthographic projection of the first via hole on the base substrate falls within the orthographic projection of the current spreading layer on the base substrate, and the orthographic projection of the current spreading layer on the base substrate falls within the orthographic projection of the second semiconductor layer on the base substrate.

19. A display device, comprising the light emitting diode chip according to any one of claims 1 to 18.

20. A method of manufacturing a light emitting diode chip, comprising:
providing a base substrate; and
forming at least two light emitting structures on the base substrate, wherein the at least two light emitting structures are spaced apart and are sequentially connected in series,
wherein the forming at least two light emitting structures on the base substrate comprises:
forming a first semiconductor layer on the base substrate;
forming a light emitting layer on a side of the first semiconductor layer away from the base substrate;
forming a second semiconductor layer on a side of the light emitting layer away from the base substrate;
forming a first insulation layer on a side of the second semiconductor layer away from the base substrate;
forming a first via hole in the first insulation layer through a dry etching process;
forming a current spreading layer on a side of the first insulation layer away from the base substrate; and
forming a first electrode on a side of the current spreading layer away from the base substrate,
wherein the first electrode is electrically connected to the current spreading layer, and the current spreading layer is electrically connected to the second semiconductor layer through the first via hole; and
wherein an orthographic projection of the first via hole on the base substrate falls within an orthographic projection of the current spreading layer on the base substrate, and the orthographic projection of the current spreading layer on the base substrate falls within an orthographic projection of the second semiconductor layer on the base substrate.
